Europäisches Patentamt

European Patent Office

Office européen des brevets

(11) Numéro de publication: **0 038 248**
A1

(12) # DEMANDE DE BREVET EUROPEEN

(21) Numéro de dépôt: **81400540.1**

(22) Date de dépôt: **03.04.81**

(51) Int. Cl.³: **H 01 L 29/80,** H 01 L 21/285, H 01 L 29/62, H 01 L 21/74

(30) Priorité: **14.04.80 FR 8008277**

(43) Date de publication de la demande: **21.10.81 Bulletin 81/42**

(84) Etats contractants désignés: **AT BE CH DE FR GB IT LI LU NL SE**

(71) Demandeur: **THOMSON-CSF, 173, Boulevard Haussmann, F-75360 Paris Cedex 08 (FR)**

(72) Inventeur: **Arnould, Jacques, Thomson-CSF SCPI 173, bld Haussmann, F-75360 Paris Cedex 08 (FR)**
Inventeur: **Tonnel, Eugène, Thomson-CSF SCPI 173, bld Haussmann, F-75360 Parix Cedex 08 (FR)**

(74) Mandataire: **de Beaumont, Michel et al, "THOMSON-CSF" SCPI 173, Bld Haussmann, F-75360 Paris Cedex 08 (FR)**

(54) **Transistor à effet de champ à jonction de puissance à fonctionnement vertical, et procédé de fabrication.**

(57)     La présente invention concerne un transistor à effet de champ à jonction de puissance à fonctionnement vertical.

Dans le cas d'un substrat de silicium (10), ce transistor comprend des rainures en U (15). Les parties supérieures des parois latérales de ces rainures sont isolées par une couche de silice (16) et les parties inférieures de ces rainures rejoignent des zones surdopées de type P⁺ (17). Du silicium polycristallin permet d'assurer un contact ohmique entre des emplacements choisis de la face supérieure du transistor et la couche de grille de type P⁺ (17).

Application à des transistors à effet de champ pouvant fonctionner à niveau de courant et de puissance élevé.

TRANSISTOR A EFFET DE CHAMP A JONCTION DE PUISSANCE A FONC-
TIONNEMENT VERTICAL, ET PROCEDE DE FABRICATION.

La présente invention concerne un transistor à effet de champ vertical de puissance à jonction et un procédé de fabrication d'un tel transistor.

L'un des premiers documents dans lequel on peut trouver une description d'un tel transistor est le brevet de Stanislas Teszner n° 1 163 241, intitulé dispositif à semiconducteur dit "transistron unipolaire de puissance", déposé le 10 décembre 1956. Les figures 5 et 6 de ce brevet sont schématiquement reproduites dans les figures 1 et 2 ci-jointes.

Comme le représente la figure 1, le brevet Teszner décrit notamment un dispositif comprenant un substrat 1 dans lequel sont formés des sillons 2 pour dégager des parties en saillie ou bâtonnets 3. Le fond de chaque sillon est rempli d'une métallisation 4. Il est précisé que les bâtonnets 3 sont de préférence de configuration cylindrique. Il est indiqué que ces bâtonnets peuvent être parallélépipédiques mais qu'alors les tensions à mettre en jeu pour assurer le fonctionnement du dispositif sont plus importantes. Une première électrode principale est solidaire de la face supérieure surdopée 5 des bâtonnets. Une deuxième électrode principale est solidaire de la surface inférieure surdopée 6 du substrat et une troisième électrode est solidaire de la métallisation de fond de sillon 4. Ce dispositif fonctionne comme un transistor à effet de champ à déplétion. En l'absence de tension appliquée sur la grille ou "électrode de goulot" 4, la présence d'une tension entre les électrodes principales permet un passage du courant entre ces électrodes. Ce courant peut être bloqué par suite de l'application d'une tension appropriée sur la grille 4.

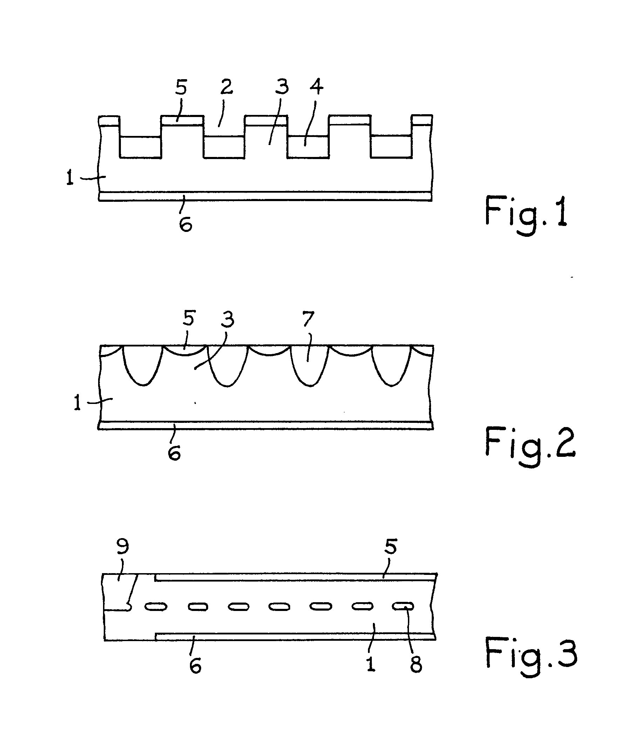

La figure 2 représente un autre mode de réalisation décrit par le brevet Teszner. Dans cette deuxième figure, de même références désignent de mêmes couches et zones que la figure 1. La différence essentielle entre les figures 2 et 1 est que, en figure 2, les bâtonnets 3 élémentaires ne sont pas séparés matériellement entre eux par des rainures mais sont isolés les uns par rapport aux autres par des régions 7 dopées selon le type de conductivité opposé de celui du substrat (par exemple P$^+$ si le substrat est de type N).

Les dispositifs décrits ci-dessus présentaient de nombreux inconvénients parmi lesquels on peut notamment citer pour celui de la figure 1 la difficulté technologique de réaliser les sillons et de les remplir partiellement d'une métallisation et les difficultés liées aux reprises de contact sur la grille métallique 4 se trouvant en renfoncement par rapport à la surface correspondante du dispositif. Le brevet ne décrit d'ailleurs pas le moyen pour reprendre ce contact.

Par contre, la structure de la figure 2 est d'une réalisation plus simple mais il semble que le fait de prévoir une couche dopée 7 s'étendant jusqu'à la surface du dispositif présente des inconvénients quant au fonctionnement de celui-ci et que la forme des zones 7 résultant d'une diffusion à partir de la surface de la plaquette semiconductrice rend difficile le blocage de ce dispositif.

Néanmoins, les avantages théoriques des structures du type de celle représentée en figure 1 paraissaient importants et l'on a recherché un autre type de structure plus facilement réalisable technologiquement et fonctionnant selon le même principe. Ainsi, depuis une vingtaine d'années, on trouve de nombreux articles et brevets décrivant des structures de transistors de puissance à effet de champ verticaux qui présentent une grille enterrée. Une telle structure, décrite par exemple dans le brevet français de Stanislas Teszner 1 317 256 du 16 décembre 1961 et ses quatre additions, est illustrée schématiquement en figure 3. La métallisation 4 de la figure 1 est remplacée par une grille enterrée 8. Cette grille est constituée de zones à niveau de dopage élevé et du type de conductivité opposé à celui du substrat 1. Des contacts avec cette grille peuvent être établis par l'intermédiaire de diffusions profondes 9 partant de la surface.

Les divers articles et brevets traitant de ces dispositifs à grille enterrée décrivent de très nombreuses variantes quant au mode de réalisation de la grille et de la prise de contact sur cette grille. Néanmoins, de façon générale, la structure de la figure 3 est obtenue à partir d'un substrat d'un premier type de conductivité, par exemple N, dans lequel sont implantés des atomes dopants de type P selon une configuration correspondant sensiblement à celle de la grille que l'on souhaite obtenir. Ensuite, une couche épitaxiée de type N est formée au-dessus du substrat puis les diffusions correspondant aux zones 5, 6 et 9, et éventuellement d'autres diffusions sont effectuées. Etant donné qu'au moment de l'ouverture du dispositif par la grille, celle-ci doit évacuer un courant de trous important au cours d'une durée brève, il est nécessaire que la résistivité transversale de la couche $P^+$ de grille soit le plus faible possible. Le niveau de dopage doit donc être initialement très important. Il convient aussi de maîtriser avec une grande précision l'étendue de la diffusion à partir de la couche initialement implantée pour que les mailles de la grille ne se ferment pas et aient une épaisseur prédéterminée. Le contrôle de cette diffusion est très difficile à réaliser notamment du fait des autres étapes de diffusion thermique qui doivent être prévues pour la formation des autres couches du substrat. Des diffusions parasites du dopant implanté peuvent également se produire lors de l'épitaxie. Les inconvénients énoncés ci-dessus sont d'autant plus notables que, dans de nombreux dispositifs que l'on a cherché à réaliser de façon pratique, les dimensions des mailles de la grille doivent être de l'ordre de quelques microns.

Ainsi, un objet de la présente invention est de prévoir une nouvelle structure de transistor de puissance à effet de champ vertical qui pallie les inconvénients structurels ou de fabrication des dispositifs de l'art antérieur.

Un autre objet de la présente invention est de prévoir un transistor de puissance à effet de champ de type vertical permettant le passage et le blocage de courants importants.

Un autre objet de la présente invention est de prévoir un nouveau procédé de fabrication de transistor de puissance à effet de champ vertical.

Pour atteindre ces objets ainsi que d'autres, la présente invention prévoit une structure dérivant de celle exposée précédemment en relation avec les figures 1 et 2 et ne comprenant pas de couche enterrée sous une couche épitaxiée selon la technique qui a été adoptée au cours de ces dernières années.

Ainsi, la présente invention prévoit un transistor à effet de champ vertical de puissance à jonction, comprenant un substrat semiconducteur d'un premier type de conductivité à faible niveau de dopage dont une première face comprend un quadrillage de rainures, les parties en saillie de cette première face correspondant à une première électrode principale et la deuxième face correspondant à une deuxième électrode principale, dans lequel les parois latérales des rainures sont revêtues d'un agent isolant sur une partie de leur hauteur à partir de leur affleurement avec la première face, dans lequel le fond et la partie non isolée des parois latérales des rainures sont entourés d'une zone du deuxième type de conductivité à niveau de dopage élevé et dans lequel les rainures sont remplies d'un matériau
conducteur formant un contact ohmique avec la zone du
deuxième type de conductivité. La deuxième face du
substrat est munie d'une couche à niveau de dopage élevé
du premier ou du deuxième type de conductivité de façon
à fournir un transistor à fonctionnement de type unipolaire ou bipolaire. La zone d'affleurement du matériau
conducteur à la surface de la rainure est recouverte
d'une couche isolante à l'exception d'emplacements où
l'on souhaite prendre un contact avec le matériau conducteur. On obtient ainsi une structure dans laquelle la
première électrode principale et l'électrode de grille
sont au même niveau plan, ce qui permet une grande
simplicité de réalisation de contact et de métallisation.

Dans un mode de réalisation particulier, le
substrat semiconducteur à partir duquel est formé le
transistor selon la présente invention est en silicium,
l'agent isolant de la partie supérieure latérale des
rainures est de la silice et le matériau conducteur
permettant d'assurer le contact avec la zone de diffusion
du deuxième type de conductivité est du silicium polycristallin.

Un procédé particulier de fabrication d'un
transistor selon la présente invention à partir d'un
substrat de silicium d'un premier type de conductivité,
par exemple de type N à faible niveau de dopage comprend
les étapes suivantes : revêtir la première face ou face
supérieure du substrat d'une couche de type $N^+$ ; revêtir
la face inférieure du substrat d'une couche de type $N^+$ ou
$P^+$ ; revêtir la face supérieure d'une couche de nitrure
de silicium ; ouvrir des fenêtres en quadrillage dans le
nitrure de silicium et procéder à une attaque anisotrope
pour former des rainures en U selon ce quadrillage ;
oxyder les parois des rainures ; enlever la couche d'oxyde au fond des rainures ; procéder à une attaque anisotrope complémentaire pour approfondir les rainures ; remplir les rainures de silicium polycristallin fortement dopé de type $P^+$ ; procéder à une étape thermique pour faire diffuser le dopant de type $P^+$ dans le substrat sous l'emplacement du sillon non protégé par la silice et oxyder, pour la transformer en silice, la surface supérieure de silicium polycristallin dans les rainures ; enlever sélectivement la couche de nitrure de silicium ; ouvrir des fenêtres en des emplacements choisis sur la couche de silice pour faire apparaître des zones de contact sur le silicium polycristallin remplissant les rainures ; procéder au dépôt d'une métallisation ; graver la métallisation pour séparer une électrode en contact avec la couche $N^+$ de la première face et une électrode en contact avec le silicium polycristallin, c'est-à-dire la grille.

L'étape d'enlèvement de la couche de silice au fond des rainures en U peut être réalisée en attaquant par bombardement ionique, d'argon ou de bore par exemple, le fond des rainures et en attaquant sélectivement cette couche de silice ayant subi l'implantation par un produit d'attaque approprié, par exemple un mélange d'acide fluorhydrique et de fluorure d'ammonium.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1 à 3 qui ont été décrites précédemment étaient destinées à rappeler l'état de la technique ;

les figures 4 et 5 représentent des vues en coupe d'un mode de réalisation de transistor à effet de champ de puissance vertical selon la présente invention prises selon des plans différents ;

la figure 6 représente une vue de dessus du dispositif selon la présente invention ;

les figures 7 à 12 illustrent des étapes de fabrication d'un transistor de puissance à effet de champ vertical selon la présente invention.

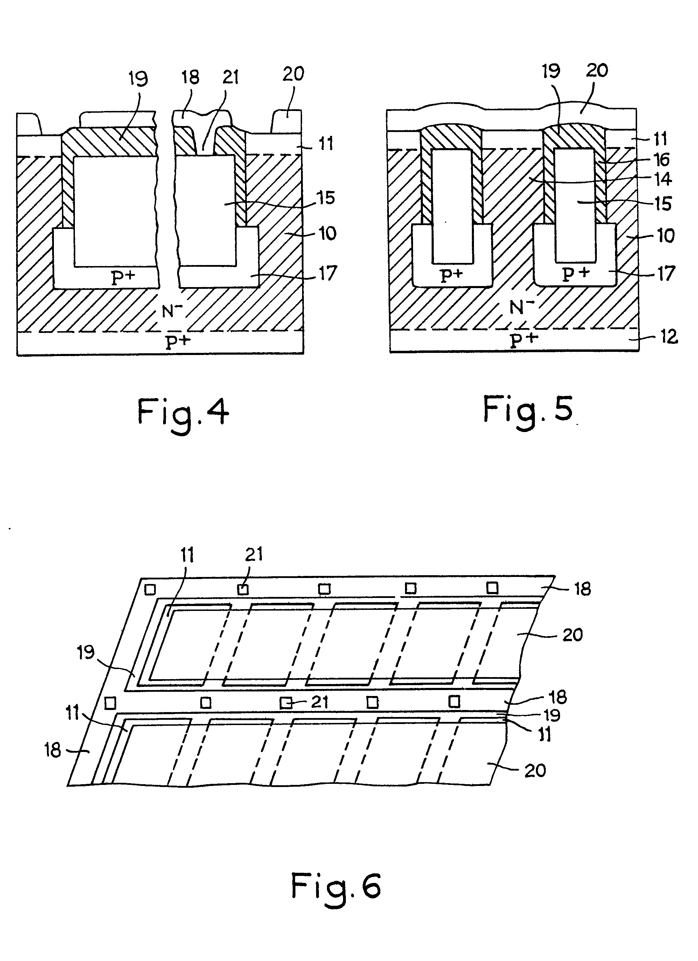

Les figures 4 et 5 représentent des vues en coupe partielle longitudinale et transversale d'un transistor selon la présente invention.

Ce transistor comprend un substrat 10 d'un premier type de conductivité et à faible niveau de dopage, par exemple $N^-$ revêtu sur sa première face ou face supérieure d'une couche à niveau de dopage élevé de type $N^+$ 11 et sur sa surface inférieure, d'une couche à niveau de dopage élevé de type $N^+$ ou $P^+$ 12. Des zones en saillie 14, de section parallélépipédique correspondant aux bâtonnets en saillie 3 de la figure 1 sont délimitées par des rainures 15. La partie supérieure de la paroi latérale de ces rainures est revêtue d'une couche d'un matériau isolant 16 ; le fond des rainures ainsi que les parties des parois latérales non isolées par la couche 16 sont entourées d'une zone 17 à niveau de dopage élevé de type $P^+$, c'est-à-dire de type opposé à celui du substrat. L'intérieur des sillons ou rainures 15 est rempli d'un produit électriquement conducteur assurant un contact ohmique avec les zones 17 pour servir de couche de conduction électrique entre une électrode 18 sur la face supérieure du substrat et la couche de type $P^+$ ou grille 17. Une deuxième électrode 20 assure le contact électrique avec la couche 11 de type $N^+$.

Dans un mode de réalisation particulier de la présente invention, la partie supérieure de la rainure 15 est isolée par une couche d'isolement 19 et seulement quelques fenêtres 21 sont prévues dans cette couche d'isolement 19 pour assurer le contact entre la métallisation 18 et le produit conducteur remplissant chaque rainure. Ceci permet, comme le représente en particulier la figure 5, de réaliser la couche métallique 20 de contact avec la couche 11 de façon continue en évitant de prévoir des ouvertures de cette couche de métallisation en regard de chacune des rainures.

On obtient ainsi, comme le montre une comparaison entre la figure 5 et la figure 1, une structure de transistor de puissance à effet de champ vertical fonctionnant de la même façon que celui de l'art antérieur mais présentant par rapport à celui-ci de nombreux avantages structurels résultant notamment du fait que : la zone diffusée de type $P^+$ 17 est nettement délimitée par la partie du sillon isolée latéralement 16 ; les contacts d'électrode principale sur la face supérieure et d'électrode de grille sont ramenés sur un même plan et leur réalisation peut être simplifiée ; enfin et surtout comme cela sera exposé ci-après, en relation avec un exemple particulier, la structure selon la présente invention peut être fabriquée de façon simple tout en obtenant une miniaturisation extrême des diverses dimensions.

Dans le cas particulier où le substrat semiconducteur 10 est un substrat de silicium, on choisira celui-ci selon une orientation (1,1,0). Les sillons 15 sont formés dans le substrat par gravure anisotrope. Les gravures forment préférentiellement, comme le représente la vue de dessus de la figure 6, des parallélogrammes d'angles 70° et 110°. Le matériau d'isolement 16 des rainures est de préférence de la silice, le matériau conducteur 15 de remplissage de ces rainures est de préférence du silicium polycristallin dopé de type $P^+$ et la zone à type de conductivité inversée 17 est de préférence une zone diffusée obtenue par diffusion dans le substrat d'atomes dopants initialement contenus dans le silicium polycristallin. Les métallisations 18 et 20 sont de préférence des métallisations d'aluminium. A titre d'exemple, on pourra réaliser un dispositif pratique présentant les caractéristiques dimensionnelles suivantes :

       - profondeur totale des sillons : 5 à 20 microns,

       - distance entre sillons : 10 à 15 microns

       - largeur des sillons : 3 à 5 microns

       - largeur ou profondeur de la couche 17:2 à 3 microns

Dans le cas où le dispositif aurait la configuration digitée représentée en vue de dessus en figure 6, le doigt de métallisation destiné à venir prendre un contact avec des ouvertures 21 en plusieurs points de la grille peut avoir une largeur de l'ordre de 30 à 50 microns.

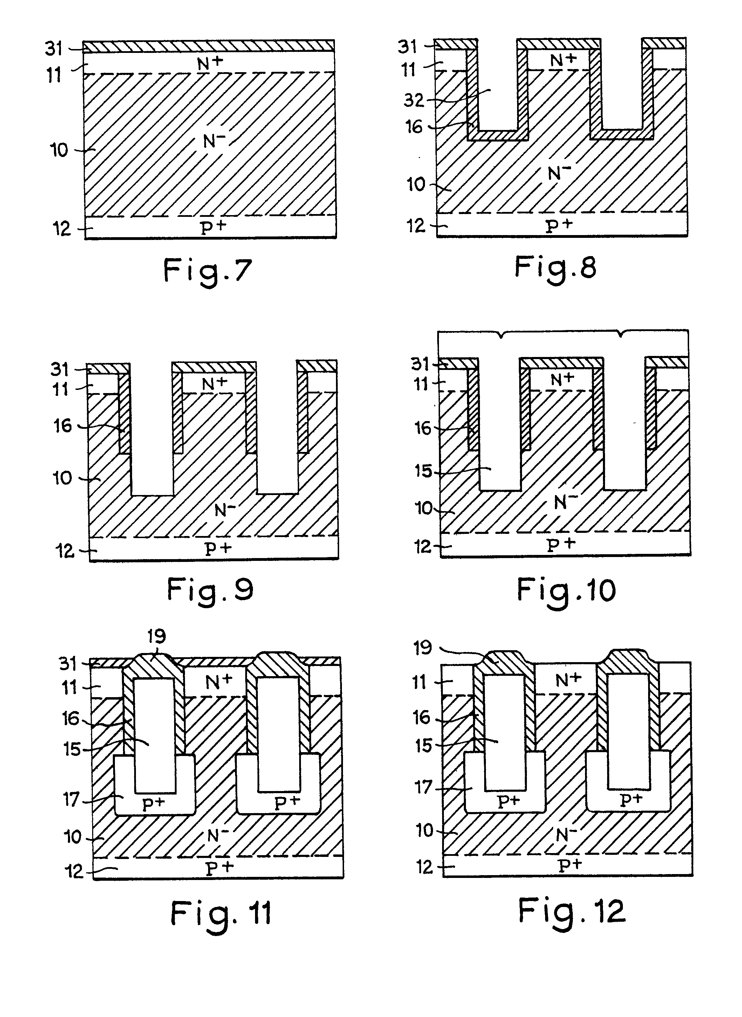

Un procédé de fabrication d'une structure telle que représentée en figures 4 à 6 réalisée sur substrat de silicium (1,1,0) va maintenant être décrit plus en détail en relation avec les figures 7 à 12.

La figure 7 représente un substrat de silicium 10 à faible niveau de dopage, sur la première face ou face supérieure duquel on a formé une couche 11 à niveau de dopage élevé de même type de conductivité N que le substrat et sur la deuxième face duquel on a formé une couche 12 à fort niveau de dopage, indiqué comme de type $P^+$ dans la figure mais pouvant aussi bien être de type $N^+$ si l'on souhaite réaliser un dispositif à fonctionnement unipolaire et non pas bipolaire. La face supérieure 11 est revêtue d'une couche de protection 31 en nitrure de silicium ($Si_3N_4$). Des ouvertures sont formées en des emplacements choisis de la couche de nitrure de silicium, par exemple selon le quadrillage en parallélogrammes représenté en vue de dessus en figure 6. Ces ouvertures dans la couche de nitrure de silicium servent de masque d'attaque pour effectuer une gravure anisotrope de la plaquette et fournir les

0038248

sillons en U 32 représentés dans la figure 8. Les arêtes des ouvertures sont alignées sur des directions 110 et les faces latérales sont constituées par des plans 111. Une étape d'échauffement thermique en atmosphère oxydante permet d'oxyder les parois des rainures de façon à former une couche d'isolement 16 en silice ($SiO_2$).

On procède ensuite à une implantation d'ions, d'argon ou de bore par exemple, selon une incidence normale à la surface de la plaquette de façon à réaliser cette implantation dans la couche de silice se trouvant au fond des rainures 32 sans affecter les faces latérales recouvertes de silice. Il est alors possible d'attaquer sélectivement par un produit d'attaque de dosage approprié le fond des sillons qui a reçu l'implantation sans attaquer les parois de ces sillons ni la couche de nitrure à la surface de la plaquette.

Comme le représente schématiquement la figure 9, après cet enlèvement de la couche d'oxyde au fond des sillons, on procède à une attaque anisotrope complémentaire pour approfondir ces sillons ou rainures qui gardent toujours néanmoins leur forme en U. On obtient ainsi des sillons dont la partie supérieure est isolée par la couche de silice 16 et dont la partie la plus profonde pénètre sans couche intermédiaire dans le silicium du substrat.

Comme le montre la figure 10, le sillon est ensuite rempli de silicium polycristallin dopé au bore 15, des techniques existant actuellement pour effectuer de tels dépôts à des températures relativement basses (inférieures à 600°C). L'épaisseur de silicium polycristallin sur la surface principale est alors sensiblement moitié de la largeur des sillons.

Comme le représente la figure 11, le silicium polycristallin en excès sur la face supérieure du dispositif est enlevé par un procédé d'attaque approprié par exemple par une attaque sous plasma et l'on procède à une étape d'échauffement pour fournir une couche de silice 19 à la partie supérieure des rainures et également pour assurer la diffusion des atomes dopants contenus dans le silicium polycristallin 15 (par exemple du bore) vers le substrat pour former la zone de type $P^+$ 17.

Lors de l'étape illustrée en figure 12 on enlève la couche de nitrure de silicium 31. Après quoi l'on procède à des ouvertures de contact dans la couche de silice 19 puis à une métallisation, par exemple d'aluminium, des faces supérieure et inférieure du dispositif. La couche d'aluminium sur la face supérieure est gravée pour séparer l'électrode principale de l'électrode de grille en contact avec le silicium polycristallin 15 aux emplacements définis par les fenêtres ouvertes dans la couche d'oxyde 19. On obtient ainsi un dispositif selon l'invention tel que représenté dans les figures 4 à 6.

Selon l'un des avantages de la présente invention, l'étape de formation de la couche de grille proprement dite 17 est l'une des dernières étapes du procédé de fabrication et n'est suivie d'aucune autre étape de diffusion, c'est-à-dire d'échauffement important. Ainsi, la profondeur ou épaisseur de la zone 17 à partir du sillon peut être contrôlée avec une grande précision. On évite les phénomènes d'exodiffusion qui rendent si difficile technologiquement la réalisation de structures à grille enterrée à pas très fin du type de celle illustrée en figure 3.

Bien entendu, le procédé de fabrication selon la présente invention est susceptible de nombreuses variantes, par exemple en ce qui concerne l'attaque du fond de la couche d'oxyde dans les sillons illustrée en figure 8 et le procédé de formation de la couche 17. Celle-ci pourrait être formée à partir d'un dopant implanté ou diffusé à partir de la structure se trouvant dans l'état de la figure 9, le silicium polycristallin 15 de remplissage des sillons étant disposé ultérieurement. Ceci permet un contrôle indépendant de la diffusion de la jonction $P^+$ et de la conductivité transversale de la grille par le remplissage du silicium polycristallin de type $P^+$ 15. Le procédé de fabrication particulier décrit en détail ci-dessus permet également d'obtenir des dimensions extrêmement miniaturisées du dispositif comme cela a été exposé précédemment en relation avec les figures 4 à 6.

En revenant sur les figures, il convient de souligner que, conformément à l'usage dans le domaine de la représentation des semiconducteurs, les diverses dimensions des couches et structures ne sont pas représentées à l'échelle, ni d'une figure à l'autre ni à l'intérieur d'une même figure. D'autre part, en ce qui concerne les figures 4 à 6, ces figures ne correspondent pas à des vues selon des plans différents d'un même mode de réalisation. Si l'on part de la figure 6, qui représente une structure à quadrillage de rainures, la figure 5 pourrait correspondre à une vue en coupe perpendiculairement à la grande longueur des sillons sous l'électrode 20, et la figure 6 montre, à titre d'exemple, comment pourraient être disposées les fenêtres 21 permettant un accès à la grille avec des électrodes principales (20) et de grille (18) digitées. Par contre la figure 4 représente une vue en coupe longitudinale d'un sillon unique n'appartenant pas à un quadrillage et la métallisation de grille 18 et la fenêtre 21 de cette figure 4 ne correspondent pas au mode de réalisation de la figure 6.

La présente invention n'est pas limitée aux modes de réalisation qui ont été explicitement décrits ci-dessus ; elle en inclut les diverses variantes et généralisations comprises dans le domaine des revendications ci-après.

13

REVENDICATIONS

1. Transistor à effet de champ à jonction de puissance à fonctionnement vertical comprenant un substrat semiconducteur (10) d'un premier type de conductivité à faible niveau de dopage dont une première face comprend un quadrillage de rainures, les parties en saillie de cette première face correspondant à une première électrode principale et la deuxième face correspondant à une deuxième électrode principale, caractérisé en ce que les parois latérales des rainures sont revêtues d'un agent isolant (16) sur une partie de leur hauteur à partir de leur affleurement avec la première face, en ce que le fond et la partie non isolée des parois latérales des rainures sont entourés d'une zone (17) du deuxième type de conductivité à niveau de dopage élevé, et en ce que ces rainures sont remplies d'un matériau conducteur (15) formant un contact ohmique avec la zone du deuxième type de conductivité et correspondant à une électrode de grille.

2. Transistor selon la revendication 1, caractérisé en ce que la deuxième face du substrat comprend une couche à niveau de dopage élevé du deuxième type de conductivité

3. Transistor selon la revendication 1, caractérisé en ce que la deuxième face du substrat comprend une couche à niveau de dopage élevé du premier type de conductivité.

4. Transistor à effet de champ selon l'une quelconque des revendications 1 à 3, caractérisé en ce que l'affleurement du matériau conducteur à la surface de la rainure est recouvert d'une couche isolante (19) à l'exception d'emplacements (21) où l'on souhaite prendre un contact avec le matériau conducteur.

5. Transistor à effet de champ selon l'une quelconque des revendications 1 à 3, caractérisé en ce que le substrat semiconducteur est un substrat de silicium, l'agent isolant de la silice, et le matériau conducteur du silicium polycristallin fortement dopé selon le second type de conductivité.

6. Transistor selon les revendications 4 et 5, caractérisé en ce qu'il comprend à sa surface supérieure des métallisations principales (20) et de grille (18) interdigitées, la métallisation principale recouvrant notamment des portions de la couche isolante (19) énoncée en revendication 4 et la métallisation de grille venant en contact avec les emplacements (21) où cette couche isolante est enlevée.

7. Procédé de fabrication d'un transistor selon la revendication 5, fabriqué à partir d'un substrat de silicium d'orientation (1,1,0) d'un premier type de conductivité et à faible niveau de dopage, sur les deux faces duquel sont formées des couches à niveau de conductivité élevé, caractérisé en ce qu'il comprend l'étape consistant à former des sillons par gravure anisotrope en U.

8. Procédé de fabrication selon la revendication 7, pour former des sillons dont la partie la moins profonde est latéralement isolée et la partie plus profonde entre directement dans le substrat, caractérisé en ce qu'il comprend les étapes suivantes :

    prévoir deux produits de protection sensibles à des produits d'attaque distincts ;

    recouvrir le substrat d'une couche du premier produit de protection ;

    former une rainure d'une première profondeur ;

    revêtir les parois de la rainure d'une couche du produit de protection de deuxième type ;

    approfondir la rainure.

9. Procédé selon la revendication 8, dans lequel le substrat est un substrat de silicium recouvert d'une couche de nitrure de silicium (31), caractérisé en ce qu'il comprend les étapes suivantes :

    ouvrir la couche de nitrure de silicium aux endroits où on souhaite effectuer les sillons ;

former ces sillons selon une première profondeur par attaque chimique d'une durée déterminée ;

procéder à une étape d'oxydation pour oxyder les parois et le fond du sillon ;

bombarder ioniquement le fond des sillons pour le rendre sélectivement sensible à une attaque chimique ;

enlever par attaque chimique la silice bombardée déposée au fond des sillons ;

approfondir les sillons par une deuxième attaque chimique.

10. Procédé de fabrication selon l'une des revendications 8 ou 9, caractérisé en ce qu'il comprend en outre l'étape suivante :

remplir les sillons de silicium polycristallin fortement dopé de type $P^+$ et procéder à une étape d'échauffement pour faire diffuser le dopant de type $P^+$ dans le substrat au voisinage du fond des sillons et de la partie la plus proche du fond des parois latérales.

11. Procédé selon la revendication 10, caractérisé en ce que le substrat est de type N et en ce que le silicium polycristallin est dopé de type $P^+$ par des atomes de bore.

12. Procédé selon l'une des revendications 10 ou 11, caractérisé en ce que la surface supérieure du silicium polycristallin contenu dans les rainures est recouverte d'une couche isolante de silice.

13. Procédé selon la revendication 12 dans lequel des électrodes métalliques sont formées sur la première face du transistor, caractérisé en ce qu'il comprend les étapes suivantes :

ouvrir en certains emplacements de la couche de silice selon la revendication 12 des fenêtres permettant un accès vers la zone de silicium polycristallin ;

déposer uniformément une couche de métallisation telle que de l'aluminium sur la première face du
dispositif ;

graver cette couche selon une structure digitée
pour séparer une électrode de grille passant sur lesdites fenêtres et une électrode principale recouvrant
la plus grande partie de la première face au-dessus
desdites couches de silice et de la zone surdopée de cette
face supérieure.

Fig.1

Fig.2

Fig.3

Fig.4

Fig.5

Fig.6

Fig.7

Fig.8

Fig.9

Fig.10

Fig. 11

Fig. 12

Office européen
des brevets
RAPPORT DE RECHERCHE EUROPEENNE

0038248

Numéro de la demande

EP 81 40 0540

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendication concernée | |
| | GB - A - 2 026 237 (TEXAS INSTRU-MENTS) <br><br> * Page 1, ligne 111 - page 3, ligne 4; revendications 1-18 * <br><br> -- | 1-7,9 13 | H 01 L 29/80 <br> 21/285 <br> 29/62 <br> 21/74 |
| | FR - A - 2 227 645 (SONY) <br><br> * Page 3, ligne 39 - page 6, ligne 16; revendications 1-4; figures 4,5,7 * <br><br> -- | 1-7,9 13 | |
| | FR - A - 2 379 913 (ZAIDAN HOJIN HANDOTAI KENKYU SHINKOKAI) <br><br> * Page 11, ligne 26 - page 12, ligne 22; figure 7 * <br><br> -- | 1 | DOMAINES TECHNIQUES RECHERCHES (Int. Cl.³) <br><br> H 01 L 29/80 <br> 21/285 <br> 29/62 <br> 21/74 |
| | DE - A - 2 910 566 (ZAIDAN HOJIN HANDOTAI KENKYU SHINKOKAI) <br><br> * Page 25, paragraphe 3 - page 27, paragraphe 1; page 39, paragraphe 3 - page 40, para-graphe 1; figures 12A, 12B * <br><br> -- | 1-5 | |
| | US - A - 4 181 542 (NIPPON GAKKI SEIZO KABUSHIKI KAISHA) <br><br> * Colonne 5, ligne 53 - colonne 9, ligne 6, revendications 1-5; figures 5,9 <br><br> -- | 1,5,7 | CATEGORIE DES DOCUMENTS CITES <br><br> X: particulièrement pertinent <br> A: arrière-plan technologique <br> O: divulgation non-écrite <br> P: document intercalaire <br> T: théorie ou principe à la base de l'invention <br> E: demande faisant interférence <br> D: document cité dans la demande <br> L: document cité pour d'autres raisons |
| | FR - A - 2 381 373 (ZAIDAN HOJIN HANDOTAI KENYU SHINKOKAI) <br><br> ./. | 1,3-5 | &: membre de la même famille, document correspondant |

Le présent rapport de recherche a été établi pour toutes les revendications

| Lieu de la recherche | Date d'achèvement de la recherche | Examinateur |
|---|---|---|
| La Haye | 07-07-1981 | VANCRAEYNEST |

OEB Form 1503.1   06.78

Office européen
des brevets

**RAPPORT DE RECHERCHE EUROPEENNE**

Numéro de la demande

00382 48

EP 81 40 0540

-2-

| Catégorie | Citation du document avec indication, en cas de besoin, des parties pertinentes | Revendica-tion concernée |
|---|---|---|
| | * Page 18, ligne 3 - page 19, ligne 1; figure 10 *<br><br>-- | |
| A | IBM TECHNICAL DISCLOSURE BULLETIN vol. 22, no. 4, septembre 1979 New York, US B.M. KEMLAGE: "Multiple depth dielectric isolation from a single mask", pages 1464-1465<br>    * En entier *<br><br>-- | 7-9 |
| A | IBM TECHNICAL DISCLOSURE BULLETIN, vol. 22, no. 7, décembre 1979, New York, US C.E. BENJAMIN: "Self-aligned recessed oxide isolation process-structure to minimize Bird's beak formation", pages 2749-2750<br>    * En entier *<br><br>-- | 7,9 |
| A | IBM TECHNICAL DISCLOSURE BULLETIN, vol. 22, no. 8A, janvier 1980 New York, US R.D. ISAAC et al.: "Method for fabricating a self-aligned ver-tical PNP transistor", pages 3393-3396<br>    * Figures 4-8 *<br><br>-- | 7-11 |
| | PATENTS ABSTRACTS OF JAPAN, vol. 3, no. 18, (E-91) 16 février 1979 page 123E91<br><br>& JP - A - 53 147481 (NIPPON DENSHIN DENWA KOSHA)<br><br>                --        ./. | 7,9-12 |

**DOCUMENTS CONSIDERES COMME PERTINENTS**

CLASSEMENT DE LA DEMANDE (Int. Cl. ³)

DOMAINES TECHNIQUES RECHERCHES (Int. Cl. ³)

OEB Form 1503.2  06.78

Office européen
des brevets

**RAPPORT DE RECHERCHE EUROPEENNE**

0038248

Numéro de demande

EP 81 40 0540

-3-

| | **DOCUMENTS CONSIDERES COMME PERTINENTS** | | **CLASSEMENT DE LA DEMANDE (Int. Cl. ³)** |
|---|---|---|---|
| Catégorie | Citation du document avec indication, en cas de besoin, des parties pertinentes | Revendication concernée | |
| EP | EP - A - 0 010 596 (IBM)<br>* Revendications 1-5 * <br><br>---- | 7-9,11 | |
| | | | **DOMAINES TECHNIQUES RECHERCHES (Int. Cl. ³)** |
| | | | |
| | | | |